# EUROPEAN PATENT APPLICATION

(11) **EP 4 589 719 A1**
(43) Date of publication of application: **23.07.2025**
(21) Application number: 22958911.4
(22) Date of filing: 24.11.2022
(51) Int. Cl.: H01M 10/42, H01M 10/48, H04L 67/1097, H01M 50/502

(54) **BATTERY MODULE COMPRISING BATTERY MANAGEMENT SYSTEM CAPABLE OF HISTORY MANAGEMENT**

(30) Priority: 14.09.2022 KR 20220115463; 17.10.2022 KR 20220133631
(71) Applicant: Bu Myeong Co., Ltd., Anyang-si, Gyeonggi-do 14084 (KR)
(72) Inventor: KIM, Chulhoon, Anyang-si Gyeonggi-do 14071 (KR)
(74) Representative: Patentanwaltskanzlei Matschnig & Forsthuber OG
(86) International application number: PCT/KR2022/018767
(87) International publication number: WO 2024/058309

(57) **Abstract**

A battery module includes a plurality of battery cells, a master battery management system (BMS), and a bus bar connecting the plurality of battery cells. The first battery cell includes a first cell controller disposed in the first battery cell and configured to communicate with the master BMS through the bus bar, and first cell memory operatively coupled with the first cell controller. The first cell controller is configured to generate first history information related to the history of the first battery cell, record the generated first history information in the first cell memory, and transmit a first signal including the generated first history information to the master BMS through the bus bar. The master BMS is configured to record the first history information included in the first signal in master memory based on the reception of the first signal from the first cell controller.

## Description

### Technical Field

The present disclosure relates to a battery module including a battery management system capable of history management.

### Background Art

A battery module may include a plurality of battery cells that are electrically connected. The plurality of battery cells may be connected in series and/or in parallel with each other. The plurality of battery cells may age at different rates. When the battery module is reused or a battery cell is replaced, the reliability of the battery module may need to be guaranteed.

The battery module may include a battery management system (BMS) for monitoring the states of the plurality of battery cells. The battery management system may monitor the plurality of battery cells constituting the battery module, and may transmit and/or receive data signals to/from the plurality of battery cells in order to control the operations of the battery cells.

### Disclosure

### Technical Problem

In order to reuse a battery module, it may be necessary to determine the state of a battery module. Depending on the purpose of reuse, conditions for a battery module to be reused may vary. For example, a battery module to be reused in an electric vehicle may require a relatively high level of battery module state in order to ensure safety. Even when a battery cell in a battery module is replaced, it may be necessary to determine the state of the battery cell to be replaced. When a battery cell or battery module is reused, it may be necessary to provide history information about the battery cell or battery module to be reused.

The technical problems to be overcome in the present document are not limited to the technical problems mentioned above, and other technical problems not mentioned will be clearly understood by those of ordinary skill in the art to which the present invention pertains from the following description.

### Technical Solution

A battery module according to one embodiment may include: a plurality of battery cells including a first battery cell and a second battery cell; a master battery management system (BMS) including master memory, and configured to manage the plurality of battery cells; and a bus bar connecting the plurality of battery cells, and electrically connected to the master BMS. The first battery cell may include a first cell controller disposed in the first battery cell and configured to communicate with the master BMS through the bus bar, and first cell memory operatively coupled with the first cell controller. The first cell controller may be configured to generate first history information related to the history of the first battery cell, record the generated first history information in the first cell memory, and transmit a first signal including the generated first history information to the master BMS through the bus bar. The master BMS may be configured to record the first history information included in the first signal in the master memory based on the reception of the first signal from the first cell controller.

A battery module according to one embodiment may include a plurality of battery cells, a master battery management system (BMS), and a bus bar. The plurality of battery cells may include a first battery cell and a second battery cell. The master BMS may be configured to manage the plurality of battery cells. The bus bar may connect the plurality of battery cells. The bus bar may be electrically connected to the master BMS. The first battery cell may include a first cell controller. The first cell controller may be disposed in the first battery cell. The first cell controller may be configured to monitor the state of health (SOH) of the first battery cell. The first cell controller may be configured to obtain a signal including a numeric value indicating the SOH of the first battery cell and transmit the signal to the master BMS through the bus bar. The master BMS may be configured to estimate the SOH of the first battery cell based at least in part on the signal.

### Advantageous Effects

In the battery module according to one embodiment, the master BMS and each of the plurality of battery cells may communicate through the bus bar, so that separate wire harnesses can be omitted. According to one embodiment, the wire harnesses may be omitted, so that design is facilitated and weight is reduced. The battery module according to one embodiment may provide reliability during reuse by providing history information about the battery module and each of the plurality of battery cells included in the battery module.

According to one embodiment, the SOH for each of the plurality of battery cells included in the battery module may be estimated, and the SOH of each of the plurality of battery cells may be relatively determined.

The effects that may be obtained from the present disclosure are not limited to the effects mentioned above, and other effects not mentioned may be clearly understood by those of ordinary skill in the art to which the present disclosure pertains from the following description.

### Description of Drawings

FIG. 1 is a schematic block diagram of a battery module according to an embodiment.
FIG. 2 is a schematic block diagram of a cell controller according to an embodiment.
FIG. 3 illustrates an example of a first battery cell constituting a battery module according to an embodiment.
FIG. 4 illustrates an example of a data packet of a signal transmitted and received through a cell controller of a battery module according to an embodiment.
FIG. 5 illustrates an example of an operation of transmitting and receiving a data signal of a plurality of battery cells of a battery module according to an embodiment.
FIG. 6 shows an example of a battery module according to one embodiment.
FIG. 7A shows an example in which a battery module according to one embodiment is reused.
FIG. 7B shows an example in which a battery cell of a battery module according to an embodiment is replaced.
FIG. 8 is a flowchart illustrating operations for managing the history of a battery module according to one embodiment.
FIG. 9 is a flowchart illustrating operations of a master BMS in the case where a battery cell of a battery module according to one embodiment is replaced.
FIG. 10 schematically shows a blockchain network for preventing the forgery and tampering of history information.
FIG. 11 is a flowchart of an example of the operations of a master BMS and a plurality of cell controllers. The
FIG. 12A is a graph showing variations in voltage over time when a battery cell is discharged.
FIG. 12B is a flowchart showing how a master BMS determines the deterioration of a battery cell based on variations in voltage over time.
FIG. 13 is a graph showing variations in voltage over time when a battery cell is discharged.
FIG. 14 is a graph showing variations in voltage over time when a battery cell is charged.

### Mode for Invention

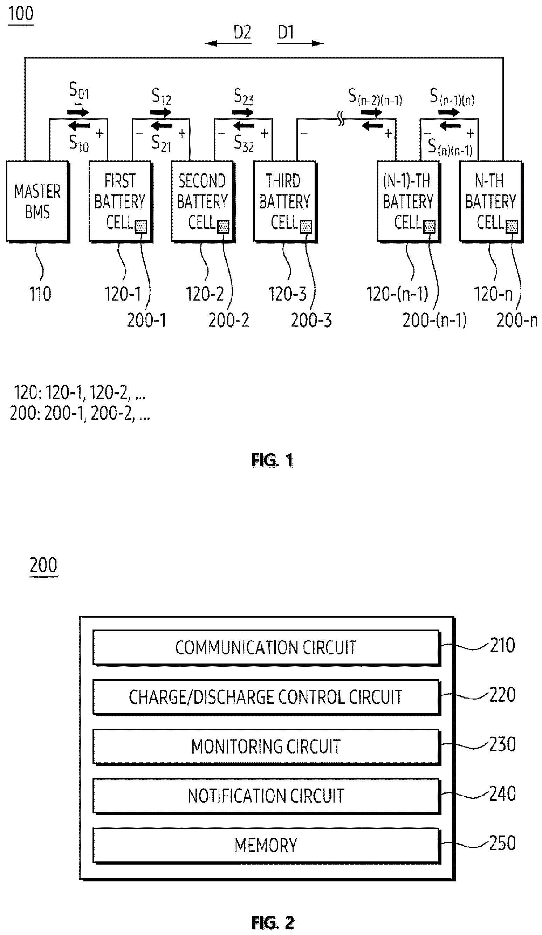

FIG. 1 is a schematic block diagram of a battery module according to an embodiment. FIG. 2 is a schematic block diagram of a cell controller according to an embodiment.

Referring to FIG. 1, a battery module 100 according to an embodiment may include a plurality of battery cells 120 connected to each other in series and a battery management system (BMS) 110 operably coupled to the plurality of battery cells 120. The plurality of battery cells 120 may be connected to each other in series to configure the battery module 100. Although not illustrated in FIG. 1, the plurality of battery cells 120 may operate as a driving source of a load by being connected with the load through an inverter or a pulse generator. A circuit described below may refer to a circuit including circuit elements interconnected to provide a specific function.

According to an embodiment, the plurality of battery cells 120 may be connected to each other in series. Referring to FIG. 1, a first battery cell 120-1 may be connected to the master BMS 110. A second battery cell 120-2 may be connected to the first battery cell 120-2. A third battery cell 120-3 may be connected to the second battery cell 120-2. According to an embodiment, the first 120-1 to nth battery cell 120-n may be sequentially connected in series in a first direction D1. For example, a negative terminal of the first battery cell 120-1 and a positive terminal of the second battery cell 120-2 may be electrically connected to each other. A negative terminal of the second battery cell 120-2 and a positive terminal of the third battery cell 120-3 may be electrically connected to each other. When the plurality of battery cells 120 are connected to each other in series, a voltage of the entire system may be set to the sum of each of the battery cells 120 constituting the plurality of battery cells 120. Although FIG. 1 illustrates that the plurality of battery cells 120 are arranged in the first direction D1, it is only for describing electrical connection of the plurality of battery cells 120, but is not limited thereto. For example, the plurality of battery cells 120 may be stacked and assembled with each other to form the battery module 100.

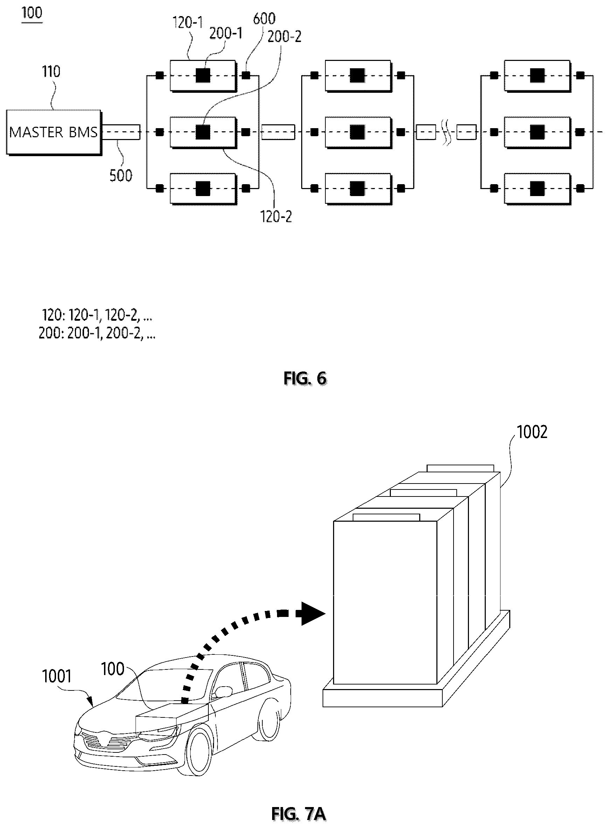

According to an embodiment, the master BMS 110 may be configured to control the overall operation of the plurality of battery cells 120. According to an embodiment, the master BMS 110 may be configured to communicate with a plurality of cell controllers 200 of the plurality of battery cells 120, via a bus bar (e.g., a bus bar 500 of FIG. 6) for connecting the plurality of battery cells 120, without a separate wire harness. The master BMS 110 may be configured to obtain information on SOH of each of the plurality of battery cells 120, via the bus bar. For example, the master BMS 110 may be configured to obtain information on the voltage and/or current of each of the plurality of battery cells 120, via the bus bar. For example, the master BMS 110 may be configured to obtain, via the bus bar, information on a state of each of the plurality of battery cells 120, such as a state of charge (SOC), a state of health (SOH), and a temperature of the plurality of battery cells 120. For example, the master BMS 110 may be configured to transmit a signal to request charging and/or discharging for each of the plurality of battery cells 120, to the plurality of cell controllers 200 disposed within the plurality of battery cells 120, via the bus bar.

According to an embodiment, the master BMS 110 may include the plurality of cell controllers 200 disposed in each of the battery cells 120 to collect information on a state of the plurality of battery cells 120. For example, the first battery cell 120-1 may include a first cell controller 200-1 disposed in the first battery cell 120-1. The second battery cell 120-2 may include a second cell controller 200-2 disposed within the second battery cell 120-2. For example, the plurality of cell controllers 200 may be disposed on a power line in the plurality of battery cells 120. The plurality of cell controllers 200 may be configured to transmit and/or receive data using a power line as a transmission medium. According to an embodiment, the plurality of battery cells 120 may transmit a signal including information on each state to the master BMS 110, by using the plurality of cell controllers 200. The master BMS 110 may transmit, to each of the plurality of battery cells 120 using the plurality of cell controllers 200, a signal to request an operation of each of the plurality of battery cells 120 and/or a signal to request information on SOH of each of the plurality of battery cells 120.

Referring to FIG. 2, the master BMS 110 may include a communication circuit 210, a charge/discharge control circuit 220, a monitoring circuit 230, a notification circuit 240, and memory 119.

According to an embodiment, the communication circuit 210 may transmit and/or receive a signal via a cell communication module 125 of the plurality of battery cells 120 and the bus bar. The communication circuit 210 may be connected to a power line for data signal transmission and power supply with the battery cells 120.

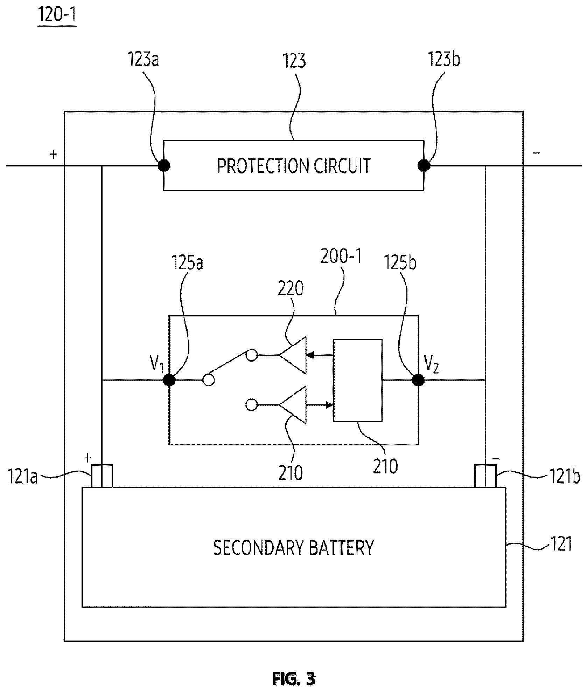

According to an embodiment, the charge/discharge control circuit 220 may control charging and/or discharging of the plurality of battery cells 120. For example, the charge/discharge control circuit 220 may perform a function of monitoring a voltage of a secondary battery (e.g., a secondary battery 121 of FIG. 3) in the plurality of battery cells 120 and a state of charge (SOC), a control function of charging and discharging of the plurality of battery cells 120, and a function for preventing over-charge and over-discharge.

According to an embodiment, the monitoring circuit 230 may be configured to monitor a state of the plurality of battery cells 120. The monitoring circuit 230 may notify the abnormality of the battery cells 120 through the notification circuit 240 when an abnormal state occurs. For example, the notification circuit 240 may be connected to a light emitting diode (LED), and a display transmitting a visual signal. For example, the notification circuit 240 may be connected to a speaker transmitting an audio signal. However, it is not limited thereto.

According to an embodiment, the memory 119 may be configured to store various information on the plurality of battery cells 120. For example, the memory 119 may store a unique ID and a state for each of the plurality of battery cells 120. For example, the memory 119 may store an ID table of battery cells 120 to be described later. For example, the memory 119 may store information on charge/discharge records, charge capacity, and remaining life of the battery cells 120.

According to an embodiment, an ID may be assigned to each of the plurality of battery cells 120. A signal transmitted from the master BMS 110 and a signal transmitted from the battery cells 120 may include information on an ID assigned to each of the plurality of battery cells 120. According to an embodiment, when a signal is received from the master BMS 110 to the plurality of cell controllers 200, the plurality of cell controllers 200 may be configured to identify information on an ID included in the signal. The plurality of cell controllers 200 may be configured to identify a battery cell to be a reception target of a signal received from the master BMS 110, based on information on the identified ID.

For example, when the master BMS 110 transmits a signal to request a specified operation to the third battery cell 120-3, the master BMS 110 may transmit a signal including information on an ID assigned to the third battery cell 120-3 to the first battery cell 120-1. The first cell controller 200-1 disposed in the first battery cell 120-1 may be configured to receive the signal and identify information on an ID included in the signal. The first cell controller 200-1 may identify that the information on an ID included in the signal does not match information on an ID assigned to the first battery cell 120-1, and transmit the signal to the second battery cell 120-2 based on the identification. The second cell controller 200-2 disposed in the second battery cell 120-2 may be configured to receive the signal, and identify information on an ID included in the signal. The second cell controller 200-2 may identify that the information on an ID included in the signal does not match information on an ID assigned to the second battery cell 120-2, and transmit the signal to the third battery cell 120-3 based on the identification. The third cell controller 200-3 disposed in the third battery cell 120-3 may be configured to receive the signal, and identify information on an ID included in the signal. The third cell controller 200-3 may identify that the information on an ID included in the signal matches the information on an ID assigned to the third battery cell 120-3, and identify a designated operation included in the signal, based on the identification. The third cell controller 200-3 may be configured to perform at least one or more operations corresponding to the designated operation, in order to perform the designated operation.

For example, when a signal including information on a state of the first battery cell 120-1 is transmitted to the master BMS 110, the master BMS 110 may identify the signal as a signal related to the first battery cell 120-1, through the information on an ID included in the signal. For example, when the plurality of battery cells 120 receive a signal including information on the charging and/or discharging of the first battery cell 120-1, the plurality of battery cells 120 may identify the signal as a signal related to the first battery cell 120-1 through the information on an ID included in the signal.

Since the battery module 100 according to an embodiment may communicate through a bus bar connecting the plurality of battery cells 120, the design for transmitting and/or receiving communication between the master BMS 110 and the plurality of battery cells 120 may be simplified.

According to an embodiment, when the master BMS 110 transmits a signal to a specific battery cell (e.g., the second battery cell 120-2), the signal may be transmitted through a battery cell (e.g., the first battery cell 120-1) other than a battery cell (e.g., the second battery cell 120-2), which is to be a reception target of the signal. In addition, when a specific battery cell (e.g., the second battery cell 120-2) transmits a signal to the master BMS 110, the signal may be transmitted to the master BMS 110 through at least another battery cell (e.g., the first battery cell 120-1).

For example, when the master BMS 110 transmits a signal to request information on a state of the third battery cell 120-3 to the third battery cell 120-3, the master BMS 110 may transmit a signal S₀₁ to the first battery cell 120-1 connected to the master BMS 110. The signal S₀₁ may be transmitted in the first direction D1. After the signal S₀₁ is transmitted to the first battery cell 120-1 connected to the master BMS 110, it may be changed into a signal S₁₂ transmitted from the first battery cell 120-1 to the second battery cell 120-2. After being transmitted to the second battery cell 120-2, the signal S₁₂ transmitted from the first battery cell 120-1 to the second battery cell 120-2 may be changed into a signal S₂₃ transmitted from the second battery cell 120-2 to the third battery cell 120-3.

For example, when the third battery cell 120-3 transmits a signal including information on a state of the third battery cell 120-3 to the master BMS 110, the signal may be transferred in a second direction D2. The signal S₃₂ transmitted from the third battery cell 120-3 to the second battery cell 120-2 may be transferred to the second battery cell 120-2. The signal S₃₂ transmitted from the third battery cell 120-3 to the second battery cell 120-2 may be changed into a signal S₂₁ transmitted from the second battery cell 120-2 to the first battery cell 120-1 after being transmitted to the second battery cell 120-2. The signal S₂₁ transmitted from the second battery cell 120-2 to the first battery cell 120-1 may be changed into the signal S₁₀ transmitted from the first battery cell 120-1 to the master BMS 110 after being transmitted to the first battery cell 120-1. The master BMS 110 may receive the signal S₁₀ and obtain information on a state of the third battery cell included in the signal S₁₀.

When a signal passes through the battery cells 120 sequentially, the strength of the signal may be reduced by impedance (e.g., a resistance inside the battery cells) inside the battery cells 120. Since the strength of a signal decreases whenever the signal passes through the battery cells 120, if the signal is transmitted through the plurality of battery cells 120, it is necessary to maintain the strength of the signal. In addition, since a collision of the signal may occur when the signal is transmitted in a different direction, it is necessary to set a transmission directionality of the signal.

FIG. 3 illustrates an example of a first battery cell constituting a battery module according to an embodiment. Hereinafter, components described with respect to a first battery cell 120-1 may be equally applied to another battery cell.

Referring to FIG. 3, the first battery cell 120-1 may include a secondary battery 121, a protection circuit 123, and a first cell controller 200-1.

According to an embodiment, the secondary battery 121 may store electrical energy. The secondary battery 121 is a secondary battery capable of charging electrical energy and discharging the charged electrical energy, and may include a negative electrode material, a positive electrode material, a separator, and an electrolyte. According to an embodiment, the first battery cell 120-1 may include at least one secondary battery 121.

According to an embodiment, a protection circuit module (PCM) 123 is a protection circuit of the secondary battery 121 capable of preventing over-discharge, over-charge, and over-current of the secondary battery 121. The over-charge of the secondary battery 121 may cause internal overheating and swelling, thereby damaging the secondary battery 121. The over-discharge of the secondary battery 121 may damage the electrode and cause a failure of the secondary battery 121. To prevent damage and/or failure of the secondary battery 121, the protection circuit 123 may block a charge circuit based on identifying that a voltage of the secondary battery 121 has reached a charging limit voltage, and may block a discharge circuit based on identifying that a voltage of the secondary battery 121 has reached a discharge limit voltage. According to an embodiment, the protection circuit 123 may obtain information on a state of the secondary battery 121 and provide the obtained information to the first cell controller 200-1.

According to an embodiment, the first cell controller 200-1 may be configured to receive a signal from the master BMS 110 or transmit a signal from the master BMS 110, by being connected between the protection circuit 123 and the secondary battery 121. For example, the first cell controller 200-1 may be connected to a power line in the first battery cell 120-1, but is not limited thereto.

According to an embodiment, the first cell controller 200-1 may obtain information on a state of the secondary battery 121 from the protection circuit 123. For example, the information on the state of the secondary battery 121 may include information on voltage, current, and temperature of the secondary battery 121, but is not limited thereto. The first cell controller 200-1 may be electrically coupled to the protection circuit 123, and may receive the information on the state of the secondary battery 121 from the protection circuit 123. The first cell controller 200-1 may be configured to transmit the received information on the state of the secondary battery 121 to the master BMS 110.

According to an embodiment, the first cell controller 200-1 may receive a signal from the master BMS 110 via a bus bar (e.g., a bus bar 500 of FIG. 6). When a signal is received from the master BMS 110 to the first cell controller 200-1, the signal is transmitted through a plurality of battery cells (e.g., the plurality of first battery cells 120-1 of FIG. 1) connected to each other, thereby reducing a strength of the signal. For example, when a signal is transmitted from the master BMS 110 to the third battery cell 120-3, the signal may be transmitted to the third battery cell 120-3 by passing through the first battery cell 120-1 and the second battery cell 120-2. When a signal is transmitted, the strength of the signal may decrease due to the impedance inside the first battery cell 120-1 and the impedance inside the second battery cell 120-2.

According to an embodiment, the first cell controller 200-1 may identify whether a target of the signal received from the master BMS 110 is the first battery cell 120-1. The signal may include information on a target ID, which is information on an ID of the first battery cell 120-1, which is to be a reception target of the signal. The first cell controller 200-1 may compare the target ID included in the signal received from the master BMS 110 with an ID assigned to the first battery cell 120-1. The first cell controller 200-1 may perform an operation corresponding to the signal, based on identifying that the target ID corresponds to the ID assigned to the first battery cell 120-1. Based on identifying that the target ID does not correspond to the ID assigned to the first battery cell 120-1, the first cell controller 200-1 may be configured to amplify the signal and then transmit the amplified signal to a second battery cell (e.g., the second battery cell 120-2 of FIG. 1) connected to the first battery cell 120-1.

For example, when a signal requesting information on a state of the first battery cell 120-1 is transmitted from the master BMS 110 to the first battery cell 120-1, the first cell controller 200-1 of the first battery cell 120-1 connected in series to the master BMS 110 may receive the signal. The signal may include information on a target ID set as an ID assigned to the first battery cell 120-1. The first cell controller 200-1 of the first battery cell 120-1 may identify a target ID included in the received signal, and identify whether the identified target ID corresponds to an ID assigned to the first battery cell 120-1. In case of identifying that the identified target ID corresponds to an ID assigned to the first battery cell 120-1, the first cell controller 200-1 may be configured to generate a signal including information on a state of the first battery cell 120-1 and transmit the generated signal to the master BMS 110.

For example, when a signal requesting information on a state of the second battery cell 120-2 is transmitted from the master BMS 110 to the second battery cell 120-2, the first cell controller 200-1 of the first battery cell 120-1 connected in series to the master BMS 110 may receive the signal. The first cell controller 200-1 of the first battery cell 120-1 may identify a target ID included in the received signal, and identify whether the identified target ID corresponds to an ID assigned to the first battery cell 120-**1.** In case of identifying that the identified target ID does not correspond to the ID assigned to the first battery cell 120-1, the first cell controller 200-1 may amplify the signal and then transmit the amplified signal to the second battery cell 120-2 connected in series to the first battery cell 120-**1.** Based on identifying that the target ID included in the signal corresponds to an ID assigned to the second battery cell 120-2, the second cell controller (e.g., the second cell controller 200-2 of FIG. 1) of the second battery cell 120-2 may generate a signal including information on a state of the second battery cell 120-2. The second cell controller 200-2 may be configured to transmit the generated signal to the master BMS 110.

Referring to FIG. 3, the first cell controller 200-1 may include a microprocessor 201 that controls transmission and/or reception of signals, an amplification circuit 202 for amplifying a signal transmitted to and/or received from the microprocessor 201, and a switch SW for controlling a transmission path of signals.

According to an embodiment, a signal transmitted to and/or received from the first cell controller 200-1 may be amplified through the amplification circuit 202 and then transmitted and/or received. When a signal is received from the outside of the first cell controller 200-1, the switch SW may provide a reception path of the signal by being closed so that the signal is received by the microprocessor 201. When a signal is transmitted from the first cell controller 200-1, the switch SW may provide a transmission path of the signal by being closed so that the signal is transmitted from the microprocessor 201.

According to an embodiment, the first cell controller 200-1 may be connected between the protection circuit 123 and the secondary battery 121. Referring to FIG. 3, the first cell controller 200-1 may include a first terminal 125a connected to a positive electrode tab 121a of the secondary battery 121 and a first terminal 123a of the protection circuit 123, and a second terminal 125b connected to a negative electrode tab 121b of the secondary battery 121 and a second terminal 123b of the protection circuit 123. A signal transmitted to the first battery cell 120-1 may be transmitted to the first cell controller 200-1 through the first end 125a of the first cell controller 200-1. The first cell controller 200-1 may identify a signal received from the master BMS 110 based on a potential difference V₂-V₁ between the second end 125b of the first cell controller 200-1 and the first end 125a of the first cell controller 200-1. For example, the first cell controller 200-1 may detect potential V₂ of the second end 125b of the first cell controller 200-1 and potential V₁ of the first end 125a of the first cell controller 200-1, identify a signal by the potential difference V₂-V₁, and receive and/or transmit the signal.

According to an embodiment, when a target ID included in the received signal does not correspond to an ID assigned to the first battery cell 120-1, the first cell controller 200-1 may apply the amplified signal to the first end 125a of the first cell controller 200-1 to transmit the signal to the second battery cell 120-2. The amplified signal applied to the first end 125a of the first cell controller 200-1 may be transmitted to the second battery cell 120-2 through the secondary battery 121. Therefore, even when the signal passes through the first battery cell 120-1, it is amplified at the first end 125a of the first cell controller 200-1, and thus the signal may maintain a certain strength while passing through the plurality of battery cells 120 connected to each other.

According to an embodiment, the battery module 100 may maintain the strength of the signal using the plurality of cell controllers 200 by the plurality of battery cells 120 connected to each other, while simplifying a transmission and/or reception structure of a communication signal between the battery cells and ensuring the stability of power supply.

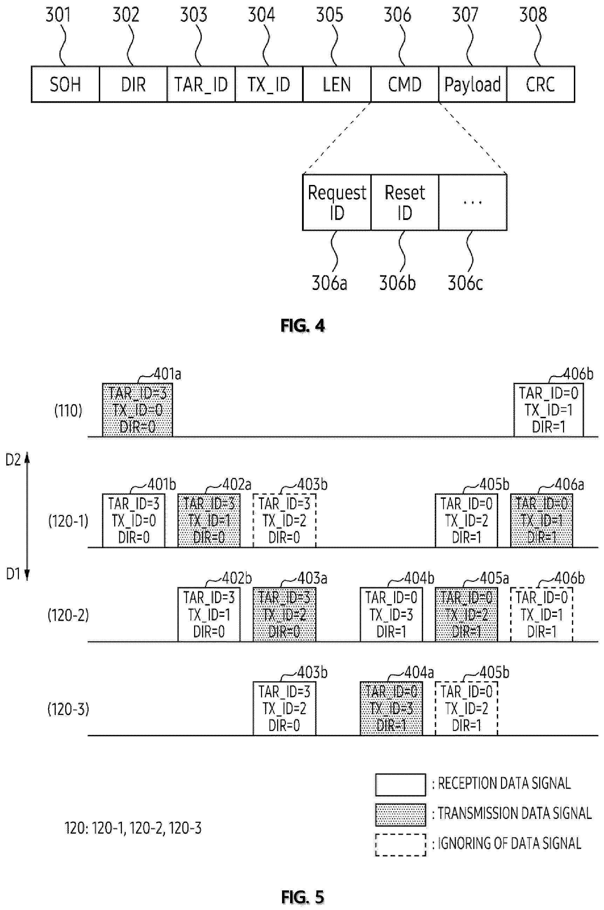

FIG. 4 illustrates an example of a data packet of a signal transmitted and received through a cell controller of a battery module according to an embodiment.

According to an embodiment, a signal transmitted and received through a plurality of cell controllers 200 of a battery module (e.g., the battery module 100 of FIG. 1) may include information for setting a directionality. Referring to FIG. 4, a data packet 300 of the signal may include information on a start of header (SOH) 301, a transmission direction of signal (DIR) 302, a target ID (TAR_ID) 303, a transmit ID (TX_ID) 304, a length of string (LEN) 305, a command indicating the command of actual operation (CMD) 306, a payload 307 that is data to be transmitted, and a cyclic redundancy check (CRC) 308 for checking errors. For example, in case that the DIR 302 is 0, a transmission direction of a signal may be the first direction of FIG. 1 (e.g., the first direction D1 of FIG. 1), and in case that the DIR 302 is 1, the transmission direction of the signal may be the second direction of FIG. 1 (e.g., the second direction D2 of FIG. 1). However, it is not limited thereto. The TX_ID 304 indicates an ID assigned to a battery management system (e.g., the master BMS 110 of FIG. 1) transmitting the corresponding signal, or a plurality of battery cells (e.g., the plurality of battery cells 120 of FIG. 1). The TAR_ID 303 may indicate an ID assigned to the master BMS 110 that will receive the corresponding signal, or the plurality of battery cells 120.

According to an embodiment, the CMD 306 included in the data packet 300 may include information related to a specific operation. Referring to FIG. 4, the CMD 306 may include a packet 306a including information for requesting the assignment of an ID for each of the plurality of battery cells 120, and a packet 306b including information for requesting the reset of an ID preassigned to the plurality of battery cells 120. For example, the plurality of battery cells 120 may transmit a data signal in which 1 is inputted to the packet 306a to the master BMS 110 in order to request ID assignment. The CMD 306 may include a packet 306c including various information, in addition to the above-described packets 306a and 206b. For example, the master BMS 110 may transmit, to the first battery cell 120-1, a data signal including information requesting information on a state of a first battery cell (e.g., the first battery cell 120-1 of FIG. 1). The first battery cell 120-1 may transmit information on the state of the first battery cell 120-1 to the master BMS 110, based on receiving the data signal.

According to an embodiment, when a signal is transmitted to any one battery cell of the plurality of battery cells 120, a cell controller among the plurality of cell controllers (e.g., the plurality of cell controllers 200 of FIG. 1), which is disposed in the any one battery cell, may compare the DIR 302 with an ID assigned to the any one of the battery cells.

For example, when the DIR 302 is 0, an ID assigned to the second battery cell 120-2 does not match TAR_ID 303, and a battery cell with an ID corresponding to the TAR_ID 303 is located in a first direction D1 than a battery cell with an ID corresponding to TX_ID 304, the second cell controller 200-2 may ignore the received signal. Since the above-described example is a case in which a signal is incorrectly transmitted in a direction opposite to the transmission direction of the signal, the second cell controller 200-2 may ignore the received signal.

For example, when the DIR 302 is 1, an ID assigned to the second battery cell 120-2 does not match TAR_ID 303, and a battery cell with an ID corresponding to the TAR_ID 303 is located in a second direction D2 than a battery cell with an ID corresponding to TX_ID 304, the second cell controller 200-2 may transmit a signal in the second direction D2. As described above, the second cell controller 200-2 may amplify and then transmit a signal. In the above example, since the signal is transmitted in the transmission direction of the signal, the second cell controller 200-2 may amplify and then transmit the received signal in the second direction D2, so that the signal may be transmitted up to a battery cell with an ID matching the TAR_ID 303. The signal may be sequentially transmitted, and then transmitted up to a battery cell where the TAR_ID 303 and the ID match, and an operation corresponding to the signal may be performed in the corresponding battery cell.

For example, when an ID assigned to the second battery cell 120-2 matches the TAR_ID 303, the second cell controller 200-2 may perform a designated operation based on CMD 306 included in the data packet 300 of the signal.

According to an embodiment, in the battery module 100 including the plurality of battery cells 120 connected to each other, signal transmission and reception between the master BMS 110 and the plurality of battery cells 120 may be smoothly performed. Through a signal including information on a signal transmission direction and a target ID, the battery module 100 according to an embodiment may prevent collision of the signal due to a serial connection.

FIG. 5 illustrates an example of an operation of transmitting and receiving a data signal of a plurality of battery cells of a battery module according to an embodiment.

The operation illustrated in FIG. 5 is performed assuming that IDs are sequentially assigned to a plurality of battery cells 120 connected in series to the master BMS 110. In the operation illustrated in FIG. 5, it is assumed that an ID assigned to the master BMS 110 is 0 (ID=0), an ID assigned to the first battery cell 120-1 is 1 (ID=1), an ID assigned to the second battery cell 120-2 is 2 (ID=2), and an ID assigned to the third battery cell 120-3 is 3 (ID=3).

Referring to FIG. 5, in order to transmit a data signal to the third battery cell 120-3, the master BMS 110 may generate a data signal 401a and transmit the generated data signal 401a to the first battery cell 120-1. The data signal 401a may include information on a target ID, information on a transmission ID, and information on a transmission direction. Referring to FIG. 5, the data signal 401a may include information in which the target ID is 3, the transmission ID is 0, and the transmission direction is a first direction D1.

According to an embodiment, the first battery cell 120-1 may receive a data signal 401b from the master BMS 110. A first cell controller (e.g., the first cell controller 200-1 of FIG. 1) of the first battery cell 120-1 may identify information on a target ID included in the data signal 401b and compare it with an ID assigned to the first battery cell 120-1. Since the information on the target ID included in the data signal 401b is 3, the first cell controller 200-1 of the first battery cell 120-1 may identify that the target ID does not correspond to the ID assigned to the first battery cell 120-1, and transmit a data signal 402a to the second battery cell 120-2. The data signal 402a may include information in which the target ID is 3, the transmission ID is 1, and the transmission direction is the first direction D1.

According to an embodiment, the second battery cell 120-2 may receive the data signal 402b from the first battery cell 120-1. A second cell controller (e.g., the second cell controller 200-2 of FIG. 1) of the second battery cell 120-2 may identify information on a target ID included in the data signal 402b and compare it with an ID assigned to the second battery cell 120-2. Since the information on the target ID included in the data signal 402b is 3, the second cell controller 200-2 of the second battery cell 120-2 may identify that the target ID does not correspond to the ID assigned to the second battery cell 120-2, and transmit a data signal 403a to the third battery cell 120-3. The data signal 403a may include information in which the target ID is 3, the transmission ID is 2, and the transmission direction is the first direction D1.

According to an embodiment, the third battery cell 120-3 may receive the data signal 403b from the second battery cell 120-2. A third cell controller (e.g., the third cell controller 200-3 of FIG. 1) of the third battery cell 120-3 may identify information on a target ID included in the data signal 403b and compare it with an ID assigned to the third battery cell 120-3. Since the information on the target ID included in the data signal 403b is 3, the third cell controller 200-3 of the third battery cell 120-3 may identify that the target ID corresponds to the ID assigned to the third battery cell 120-3, and perform an operation corresponding to the data signal 403b.

According to an embodiment, when the first battery cell 120-1 receives the data signal 403b from the second battery cell 120-2, the first cell controller 200-1 may check information included in the data signal 403b. Since the transmission ID included in the data signal 403b is 2 and the transmission direction is the first direction D1, the first cell controller 200-1 of the first battery cell 120-1 may ignore the data signal 403b.

According to an embodiment, the third battery cell 120-3 may perform an operation corresponding to the information included in the data signal 403b. When the information included in the data signal 403b includes a request for information on a state of the third battery cell 120-3, the third battery cell 120-3 may transmit a data signal 404a including the information on the state of the third battery cell 120-3 to the second battery cell 120-2. The data signal 404a may include information on a target ID, information on a transmission ID, and information on a transmission direction. Referring to FIG. 5, the data signal 404a may include information in which the target ID is 0, the transmission ID is 3, and the transmission direction is the second direction D2.

According to an embodiment, the second battery cell 120-2 may receive a data signal 404b from the third battery cell 120-3. The second cell controller 200-2 of the second battery cell 120-2 may identify information on a target ID included in the data signal 404b and compare it information with an ID assigned to the second battery cell 120-2. Since the information on the target ID included in the data signal 404b is 0, the second cell controller 200-2 of the second battery cell 120-2 may identify that the target ID does not correspond to the ID assigned to the second battery cell 120-2 and transmit a data signal 405a to the first battery cell 120-1. The data signal 405a may include information in which the target ID is 0, the transmission ID is 2, and the transmission direction is the second direction D2.

According to an embodiment, the first battery cell 120-1 may receive a data signal 405b from the second battery cell 120-2. The first cell controller 200-1 of the first battery cell 120-1 may identify information on a target ID included in the data signal 405b and compare it with an ID assigned to the first battery cell 120-1. Since the information on the target ID included in the data signal 405b is 0, the first cell controller 200-1 of the first battery cell 120-1 may identify that the target ID does not correspond to the ID assigned to the first battery cell 120-1 and transmit a data signal 406a to the master BMS 110. The data signal 406a may include information in which the target ID is 0, the transmission ID is 1, and the transmission direction is the second direction D2.

According to an embodiment, when the third battery cell 120-3 receives the data signal 405b from the second battery cell 120-2, the third cell controller 200-3 of the third battery cell 120-3 may check information included in the data signal 405b. Since the transmission ID included in the data signal 405b is 2 and the transmission direction is the second direction D2, the third cell controller 200-3 of the third battery cell 120-3 may ignore the data signal 405b.

According to an embodiment, the master BMS 110 may receive a data signal 406b from the first battery cell 120-1. The master BMS 110 may identify information on a target ID included in the data signal 406b and compare it with an ID assigned to the master BMS 110. Since the information on the target ID included in the data signal 406b is 0, the master BMS 110 may identify that the target ID corresponds to the ID assigned to the master BMS 110. The master BMS 110 may receive the data signal 406b.

According to an embodiment, when the second battery cell 120-2 receives the data signal 406b from the first battery cell 120-1, the second cell controller 200-2 of the second battery cell 120-2 may check information included in the data signal 406b. Since the transmission ID included in the data signal 406b is 1 and the transmission direction is the second direction D2, the second cell controller 200-2 of the second battery cell 120-2 may ignore the data signal 406b.

As described above, a signal transmission structure of a plurality of battery cells 120 connected to the master BMS 110 may be simply performed through a plurality of cell controllers (e.g., the plurality of cell controllers 200 of FIG. 1). According to an embodiment, information included in a transmitted and received signal may prevent errors in signal transmission and improve accuracy.

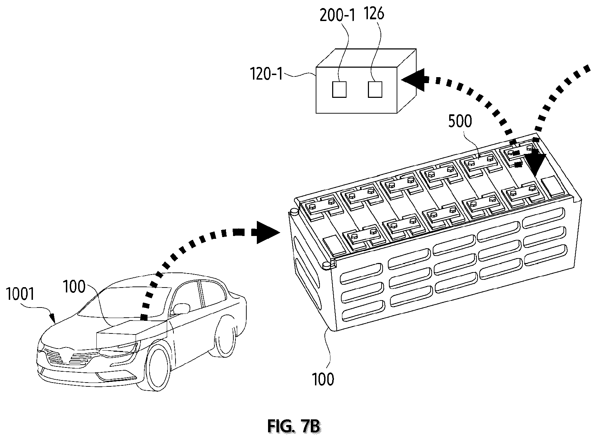

FIG. 6 shows an example of a battery module according to one embodiment. FIG. 7A shows an example in which a battery module according to one embodiment is reused. FIG. 7B shows an example in which a battery cell of a battery module according to an embodiment is replaced.

Referring to FIG. 6, a battery module 100 according to one embodiment may include a plurality of battery cells 120, a master battery management system (BMS) 110, a bus bar 500, and switches 600.

The battery module 100 according to one embodiment may include the master BMS 110 for managing the states of health (SOHs) of the plurality of battery cells 120. Reference may be made to the plurality of battery cells 120 and the master BMS 110 described above as the plurality of battery cells 120 and the master BMS 110. The contents described with reference to FIGS. 1 to 5 may be applied equally, so that redundant descriptions will be omitted.

According to one embodiment, the bus bar 500 may connect the plurality of battery cells 120 to each other. For example, when the plurality of battery cells 120 are connected in series, the bus bar 500 may connect the positive terminal of each battery cell to the negative terminal of another battery cell. Although the bus bar 500 shown in FIG. 6 is depicted in portions of a connection line between the plurality of battery cells 120, it may be arranged throughout the overall connection line between the plurality of battery cells 120. The bus bar 500 may be electrically connected to the master BMS 110. For example, the master BMS 110 and at least some of the plurality of battery cells 120 may be connected to each other through the bus bar 500. However, the present disclosure is not limited thereto.

According to one embodiment, the master BMS 110 may be configured to communicate with the plurality of battery cells 120 through the bus bar 500. The master BMS 110 may transmit signals to a plurality of cell controllers 200 through the bus bar 500, and the plurality of cell controllers 200 may transmit signals to the master BMS 110 through the bus bar 500. For example, when the master BMS 110 transmits a signal to the second battery cell 120-2, the signal may be transmitted to the second battery cell 120-2 through the bus bar 500. As shown in FIG. 1, when the first battery cell 120-1 and the second battery cell 120-2 are connected in series, the signal may pass through the first battery cell 120-1 and may then be transmitted to the second battery cell 120-2. The signal may include information about an ID (e.g., TAR_ID 303 of FIG. 3) assigned to the second battery cell 120-2 that will receive the signal. The first cell controller 200-1 may identify the information, may amplify a received signal, and may then transmit the received signal to the second battery cell 120-2. As shown in FIG. 6, when the first battery cell 120-1 and the second battery cell 120-2 are connected in parallel, the signal may be directly transmitted from the master BMS 110 to the second battery cell 120-2. However, the present disclosure is not limited thereto. Since reference may be made to the operations described with reference to FIGS. 1 to 5 as the above signal transmission and/or reception operations, redundant descriptions will be omitted.

In one embodiment, each of the switches 600 may be configured to electrically connect or disconnect any one of the plurality of battery cells 120 to and from the remaining battery cells. In one embodiment, the switch 600 may electrically connect or disconnect the first battery cell (120-1) and the second battery cell 120-2 to and from each other.

According to one embodiment, the plurality of battery cells 120 included in the battery module 100 may be replaceable and/or reusable. Referring to FIG. 7A, the battery module 100 may be reused in a second device 1002 that is different from a first device 1001 (e.g., an electric vehicle) after being used in the first device 1001. The battery module 100 that is placed and used in the first device 1001 may need to be replaced after a predetermined period of use. The operating conditions of the battery module 100 used for the operation of the load of the first device 1001 may be different from the operating conditions of the battery module 100 used for the operation of the load of the second device 1002. For example, when the first device 1001 is an electric vehicle and the second device 1002 is an energy storage system (ESS), the conditions of the battery modules 100 may be different from each other. In the case of an electric vehicle, the usage conditions of the battery module 100 may be strict due to safety issues during driving. When a battery module 100 used in an electric vehicle satisfies the conditions (e.g., the SOH, i.e., the remaining capacity, of the battery module 100) for use in an electric vehicle, it may be collected and used in the same manner in an electric vehicle again. In contrast, when a battery module 100 used in an electric vehicle does not satisfy the conditions for use in an electric vehicle, it may be collected and used in an ESS. Even in the case of a battery module 100 that does not satisfy the conditions for use in an electric vehicle, it may be used in an ESS, so that the conservation of resources may be possible through the reuse thereof.

Referring to FIG. 7B, a part of the plurality of battery cells 120 in the battery module 100 may be replaceable. For example, the aging rates of the plurality of battery cells 120 may be different. For example, since the operating environments of the plurality of battery cells 120 may be different, the aging rates may be different. Depending on the aging states of the plurality of battery cells 120, a part of the plurality of battery cells 120 may need to be replaced. For example, when the first battery cell 120-1 is aged and determined to be unusable, only the first battery cell 120-1 may be replaced without the need to replace the overall battery module 100.

According to one embodiment, the plurality of cell controllers 200 may be configured to obtain data on the SOHs of the plurality of battery cells 120 and transmit the obtained data to the master BMS 110 through the bus bar 500.

For example, the first cell controller 200-1 may be configured to monitor the SOH of the first battery cell 120-1. For example, the first cell controller 200-1 may be configured to obtain data on at least one of the voltage, current, temperature, and charging and/or discharging-based SOC change of the first battery cell 120-1. The first cell controller 200-1 may be configured to obtain the data independently of whether the first battery cell 120-1 is activated. For example, the first cell controller 200-1 may be configured to, in the state in which the first battery cell 120-1 is activated (e.g., a turn-on state), measure the temperature, operating voltage, and/or operating current of the first battery cell 120-1 and obtain data related to the measured temperature, operating voltage, and/or operating current. For example, the first cell controller 200-1 may be configured to, in the state in which the first battery cell 120-1 is inactivated (e.g., a sleep state, or a turn-off state), measure the open circuit voltage of the first battery cell 120-1 and obtain data related to the measured open circuit voltage. The above-described data is merely exemplary, and the present disclosure is not limited thereto. The first cell controller 200-1 may be configured to monitor the SOH of the first battery cell 120-1 based at least in part on the above data. The first cell controller 200-1 may transmit data related to the SOH of the first battery cell 120-1 to the master BMS 110. The operation of the first cell controller 200-1 may be substantially equally applied to the remaining cell controllers (e.g., the second cell controller 200-2).

For example, the master BMS 110 may be configured to, based on the obtainment of data related to the SOH of the first battery cell 120-1 from the first cell controller 200-1, identify the state of the first battery cell 120-1 and determine whether to replace it. For example, the master BMS 110 may identify whether the replacement of the first battery cell 120-1 is necessary by comparing predetermined reference data with the data related to the SOH of the first battery cell 120-1. The master BMS 110 may be configured to, when it is determined that the replacement of the first battery cell 120-1 is necessary, notify a user of the replacement of the first battery cell 120-1. For example, the master BMS 110 may provide a visual signal and/or auditory signal adapted to provide notification that the replacement of the first battery cell 120-1 is necessary to the user through a display and/or speaker. The user may recognize that the replacement of the first battery cell 120-1 is necessary through the signal.

For example, when the battery module 100 is reused or when the first battery cell 120-1 of the battery module 100 is replaced, the management of usage history may be necessary. For example, information about whether the battery module 100 was used in the first device 1001 or the second device 1002, the manufacturing information of the plurality of battery cells 120, and information about charging and/or discharging history may be necessary.

According to one embodiment, the first battery cell 120-1 may include first cell memory 126 that is operatively connected to the first cell controller 200-1. The first cell controller 200-1 may generate first history information related to the history of the first battery cell 120-1, and may record the generated first history information in the first cell memory 126. The master BMS may be configured to manage the usage history of the first battery cell 120-1 through the first history information recorded in the first cell memory 126. Although the above descriptions have been described using the first battery cell 120-1 as an example, they may be substantially equally applied to other battery cells. For example, the second battery cell 120-2 may include second cell memory configured to store second history information related to the second battery cell 120-2.

For example, when the overall battery module 100 is reused in another device (e.g., an ESS), the master BMS 110 of the battery module 100 may provide the user with the history information of each of the plurality of battery cells 120. For example, the user may determine whether the battery module 100 used in the first device 1001 can be used in the second device 1002 based on the history information of the plurality of battery cells 120. For example, the master BMS 110 may determine whether the battery module 100 used in the first device 1001 can be used in the second device 1002 based on the history information of the plurality of battery cells 120.

For example, when the first battery cell 120-1 is replaced, the master BMS 110 may request the first history information from the first cell controller 200-1 of the replaced first battery cell 120-1. In response to the reception of a signal requesting the first history information from the master BMS 110, the first cell controller 200-1 may transmit the first history information stored in the first cell memory 126 to the master BMS 110 through the bus bar 500. The master BMS 110 may receive the first history information of the replaced first battery cell 120-1 and provide the received first history information to the user. The method by which the master BMS 110 provides the first history information to the user may be various without limitations. For example, the first history information may be provided as visual information and/or auditory information through a display device and/or a speaker. For example, the master BMS 110 may transmit the first history information to a user terminal (e.g., a smartphone, a tablet, or a PC). The master BMS 110 may determine whether the replaced first battery cell 120-1 is available based on the first history information.

Operations for managing the history of battery cells will be described below.

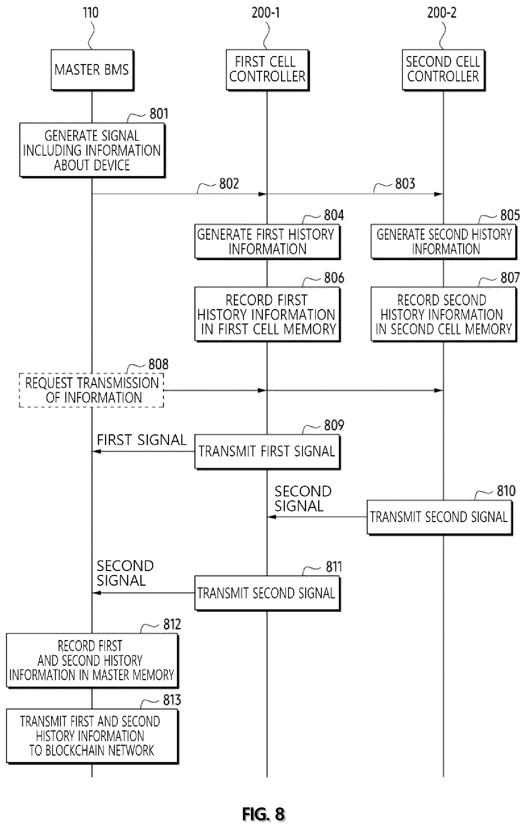

FIG. 8 is a flowchart illustrating operations for managing the history of a battery module according to one embodiment. The operations shown in FIG. 8 may be operations when a master BMS 110, a first battery cell 120-1, and a second battery cell 120-2 are sequentially connected.

Referring to FIG. 8, in operation 801, the master BMS 110 may generate a signal including information about a device. Reference may be made to the device (e.g., the first device 1001 of FIG. 7A, or the second device 1002 of FIG. 7A), in which the battery module 100 is used, as the above device. For example, the master BMS 110 may be configured to generate a signal including information about an electric vehicle when the battery module 100 is used in the electric vehicle. For example, the master BMS 110 may be configured to generate a signal including information about an ESS when the battery module 100 is used in the ESS.

In operation 802, the master BMS 110 may transmit the signal including the information about the device to the first cell controller 200-1. For example, the master BMS 110 may transmit the signal including the information about the device, in which the battery module 100 is used, to the first cell controller 200-1 through the bus bar 500. Based on the reception of the signal, the first cell controller 200-1 may store the information about the device included in the signal in the first cell memory 126.

In operation 803, the first cell controller 200-1 may transmit the signal to the second cell controller 200-2 based on the reception of a signal including the information about the device from the master BMS 110. The first cell controller 200-1 may amplify the signal received from the master BMS 110 and transmit the signal to the second cell controller 200-2. The amplification of the signal may compensate for the intensity of the signal that is attenuated as the signal including the information about the device passes through the first battery cell 120-1. For example, the first cell controller 200-1 may be configured to amplify the signal by the intensity that is attenuated when the signal passes through the first battery cell 120-1 based on the internal impedance of the first battery cell 120-1 and then transmit the signal to the second cell controller 200-2.

In operation 804, the first cell controller 200-1 may generate first history information about the history of the first battery cell 120-1. The first history information may include information about at least one of the manufacturer, manufacturing date, pre-use state, SOH, charging history, discharging history, and repair history of the first battery cell 120-1. The manufacturer of the first battery cell 120-1 may include information about the manufacturer of the first battery cell 120-1. The manufacturing date of the first battery cell 120-1 may include information about the date on which the manufacturing of the first battery cell 120-1 was completed. The pre-use state of the first battery cell 120-1 may include information about the state (e.g., the capacity) of the first battery cell 120-1 immediately after manufacture. The SOH of the first battery cell 120-1 may include information about changes in the SOH of the first battery cell 120-1 over time and the SOH of the first battery cell 120-1 at the present time. The charging history of the first battery cell 120-1 may include information about the number of times the first battery cell 120-1 has been charged, the amount of charging, the voltage of charging, and the current of charging. The discharging history of the first battery cell 120-1 may include information about the number of times the first battery cell 120-1 has been discharged, the amount of discharging, the voltage of discharging, and the current of discharging. The repair history of the first battery cell 120-1 may include information about the repair details, repair company, and repair date of the first battery cell 120-1. The first cell controller 200-1 may generate the first history information whenever an event occurs. For example, the event may include events such as the manufacturing of the first battery cell 120-1, the charging of the first battery cell 120-1, the discharging of the first battery cell 120-1, the usage of the first battery cell 120-1, and the repairing of the first battery cell 120-1. The first history information may also include various types of information related to the usage of the first battery cell 120-1.

In operation 805, the second cell controller 200-2 may generate second history information about the history of the second battery cell 120-2. Operation 805 may be substantially the same as operation 804. The descriptions for operation 804 may be substantially equally applied to operation 805.

In operation 806, the first cell controller 200-1 may record the first history information in the first cell memory 126. Whenever the first history information is generated, the first cell controller 200-1 may record the generated first history information in the first cell memory 126. For example, when the first battery cell 120-1 is repaired, the first cell controller 200-1 may generate first history information including information about the repair of the first battery cell 120-1 and record the generated first history information in the first cell memory 126. The first cell memory 126 may be configured to store the first history information.

In operation 807, the second cell controller 200-2 may record the second history information in the second cell memory. Operation 807 may be substantially the same as operation 806. The descriptions for operation 806 may be substantially equally applied to operation 807.

In operation 808, the master BMS 110 may request the first cell controller 200-1 and the second cell controller 200-2 to transmit a first signal including the stored first history information and/or a second signal including the second history information. The signals may be transmitted from the master BMS 110 to the first cell controller 200-1 and the second cell controller 200-2 through the bus bar 500 (e.g., the bus bar 500 500 of FIG. 6). For example, the master BMS 110 may transmit the signals to the first cell controller 200-1 and the second cell controller 200-2 at every period designated by a user. For example, the master BMS 110 may transmit the signals to the first cell controller 200-1 and/or the second cell controller 200-2 when a designated event occurs.

According to one embodiment, operation 808 may be omitted. When operation 808 is omitted, the first cell controller 200-1 and/or the second cell controller 200-2 may perform operations 809, 810, and 811, which will be described later, even without a separate request from the master BMS 110. According to one embodiment, operation 808 may be performed based on the states of the first battery cell 120-1 and/or the second battery cell 120-2. According to one embodiment, the first cell controller 200-1 and/or the second cell controller 200-2 may be configured to, while the first battery cell 120-1 and/or the second battery cell 120-2 are in operation, transmit the first history information stored in the first cell memory 126 and/or the second history information stored in the second cell memory to the master BMS 110 through the bus bar 500 without receiving a separate request signal from the master BMS 110. When the first battery cell 120-1 and/or the second battery cell 120-2 are in operation, it may mean that the first battery cell 120-1 and/or the second battery cell 120-2 are supplying power to a load.

According to one embodiment, the master BMS 110 may be configured to, when the first battery cell 120-1 and the second battery cell 120-2 are in a turn-off state in which they are not supplying power to a load, a low-power operation state, or a sleep state, transmit a signal adapted to request the transmission of the first history information and/or the second history information to the first cell controller 200-1 and/or the second cell controller 200-2. In the above-described case, the power consumption of the first battery cell 120-1 may need to be minimized, so that the first cell controller 200-1 and/or the second cell controller 200-2 may be configured to transmit the first history information and the second history information to the master BMS 110 based on reception of the signal. For example, when the first cell controller 200-1 and the second cell controller 200-2 continue to perform the operation of transmitting signals to the master BMS 110 in a situation where the driving power of a load is insufficient, a situation in which the load cannot be driven due to lack of power may occur. The first cell controller 200-1 and/or the second cell controller 200-2 may minimize the power consumption of the first battery cell 120-1 and/or the second battery cell 120-2 attributable to the transmission of data.

In operation 809, the first cell controller 200-1 may transmit a first signal including first history information to the master BMS 110. The first signal may be transmitted to the master BMS 110 through the bus bar 500. For example, the first cell controller 200-1 may transmit a first signal including the first history information stored in the first cell memory 126 to the master BMS 110 based on the reception of a signal requesting the transmission of the first signal from the master BMS 110. For example, the first cell controller 200-1 may transmit the first signal to the master BMS 110 at every period designated by a user. For example, the first cell controller 200-1 may transmit the first signal to the master BMS 110 when an event occurs.

In operation 810, the second cell controller 200-2 may transmit a second signal including second history information to the first cell controller 200-1. Operation 810 may be substantially the same as operation 809. The descriptions for operation 809 may be substantially equally applied to operation 810.

In operation 811, the first cell controller 200-1 may transmit the received second signal to the master BMS 110 based on the reception of the second signal from the second cell controller 200-2. The first cell controller 200-1 may amplify the second signal received from the second cell controller 200-2 and transmit it to the master BMS 110. The amplification of the signal may compensate for the intensity of the signal that is attenuated as the second signal including the second history information passes through the first battery cell 120-1. For example, the first cell controller 200-1 may be configured to amplify the second signal by the intensity that is attenuated when the signal passes through the first battery cell 120-1 based on the internal impedance of the first battery cell 120-1 and then transmit the amplified second signal to the master BMS 110.

In operation 812, the master BMS 110 may record the first history information and the second history information in master memory (e.g., the master memory 115 of FIG. 2) based on the reception of the first signal including the first history information and/or the second signal including the second history information. The master memory 115 may be configured to store history information for each of the plurality of battery cells 120. When the master BMS 110 receives the first signal, it may update information about the history of the first battery cell 120-1 by recording the first history information included in the first signal in the master memory 115. When the master BMS 110 receives the second signal, it may update information about the history of the second battery cell 120-2 by recording the second history information included in the second signal in the master memory 115. Information about each of the plurality of battery cells 120 stored in the master memory 115 may be continuously updated.

According to one embodiment, when the battery module 100 is reused, the master BMS 110 may provide the history information of the plurality of battery cells 120 constituting the battery module 100. For example, when the battery module 100 is separated from the first device 1001 and reused in the second device 1002, the master BMS 110 may provide the history information of each of the plurality of battery cells 120 based on the connection to the second device 1002. For example, the user may obtain history information for each of the plurality of battery cells 120 stored in the master memory 115 through the master BMS 110, and may determine whether to reuse the battery module 100 based on the information. According to one embodiment, when at least one of the plurality of battery cells 120 is replaced, the history information of the battery cell to be replaced may be provided. For example, when the first battery cell 120-1 is separated and connected to another battery module 100, the master BMS 110 in the newly connected battery module 100 may obtain the first history information stored in the first cell memory 126 of the first battery cell 120-1. The master BMS 110 may obtain information about the first battery cell 120-1 based on the obtainment of the first history information. For example, the master BMS 110 of the new battery module 100 may identify whether the first battery cell 120-1 is reusable, whether the usage history of the first battery cell 120-1 is suitable for reuse, and/or the like. Since the battery module 100 according to one embodiment can manage the history of each of the plurality of battery cells 120, it may provide high reliability for the battery module 100 when reused.

In operation 813, the master BMS 110 may transmit the first history information and/or the second history information to a blockchain network. Since the first history information and/or the second history information is stored in the blockchain network, the forgery and tampering of the first history information and/or the second history information may be prevented. For example, the first history information and/or the second history information may be stored in a plurality of nodes 701 within the blockchain network in a distributed manner.

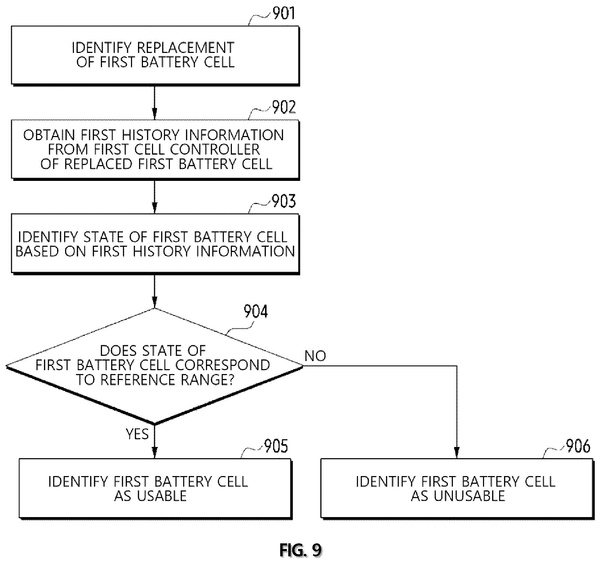

FIG. 9 is a flowchart illustrating operations of a master BMS in the case where a battery cell of a battery module 100 according to one embodiment is replaced.

Referring to FIG. 9, in operation 901, the master BMS 110 may identify the replacement of the first battery cell 120-1. For example, when the master BMS 110 identifies that the first battery cell 120-1 is separated and a new first battery cell 120-1 is connected, the master BMS 110 may identify that the first battery cell 120-1 has been replaced. However, the present disclosure is not limited thereto.

In operation 902, the master BMS 110 may obtain first history information from the first cell controller 200-1 of the replaced first battery cell 120-1. For example, the master BMS 110 may transmit a signal requesting the transmission of a signal including the first history information to the first cell controller 200-1 based on the identification of the replacement of the first battery cell 120-1. The first cell controller 200-1 may transmit a signal including the first history information to the master BMS 110 through the bus bar 500 based on the reception of the request signal.

In operation 903, the master BMS 110 may identify the state of the first battery cell 120-1 based on the first history information received from the first cell controller 200-1. For example, the master BMS 110 may be configured to identify the state of the first battery cell 120-1 based on the SOH, charging history, and/or discharging history of the first battery cell 120-1 included in the first history information.

In operation 904, the master BMS 110 may identify whether the state of the identified first battery cell 120-1 corresponds to a reference range. The master BMS 110 may compare the state of the first battery cell 120-1 with the predetermined reference range. The predetermined reference range may be determined based on a device to which the battery module 100 is connected. For example, the reference range in the case where the battery module 100 is connected to an electric vehicle and the reference range in the case where the battery module 100 is connected to an ESS may be different from each other. The reference range for the electric vehicle may be stricter than the reference range for the ESS. For example, the reference range for the electric vehicle may be about 80% or more of the SOH of the first battery cell 120-1 immediately after manufacture. The reference range for the ESS may be about 60% or more of the SOH of the first battery cell 120-1 immediately after manufacture. The master BMS 110 may determine whether the state of the replaced first battery cell 120-1 corresponds to the predetermined reference range.

In operation 905, the master BMS 110 may identify that the replaced first battery cell 120-1 is available based on the identification that the state of the first battery cell 120-1 corresponds to the reference range. When the first battery cell 120-1 is available, the master BMS 110 may supply power to a load through the first battery cell 120-1.

In operation 906, the master BMS 110 may identify that the replaced first battery cell 120-1 is unusable based on the identification that the state of the first battery cell 120-1 is different from the reference range. When the first battery cell 120-1 is unusable, the master BMS 110 may stop supplying power to the load and provide notification that the first battery cell 120-1 is unusable. For example, the master BMS 110 may provide visual information and/or auditory information about the fact that the replaced first battery cell 120-1 is unusable through a display device and/or a speaker. For example, the master BMS 110 may transmit a signal adapted to provide notification that the replaced first battery cell 120-1 is unusable to a user terminal (e.g., a smartphone, a tablet, or a PC) of a user. The user may recognize that the replaced first battery cell 120-1 is unusable through the above notification. When at least a part of the plurality of battery cells 120 is replaced, the battery module 100 according to one embodiment may provide the safe reuse of the battery cell by determining whether the replaced battery cell is usable and using it based on the determination. For example, the battery module 100 may prevent a safety-related accident (e.g., a fire) that may occur when a non-reusable battery cell is reused.

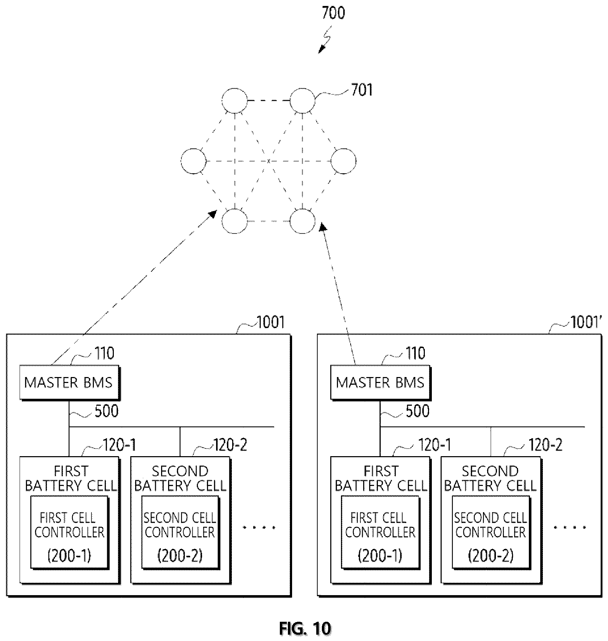

FIG. 10 schematically shows a blockchain network for preventing the forgery and tampering of history information.

Referring to FIG. 10, the master BMS 110 may transmit the first history information and/or the second history information, received from the first battery cell 120-1 and/or the second battery cell 120-2, to the blockchain network 700. For example, the master BMS 110 may receive the first history information and/or the second history information from the first cell controller 200-1 and/or the second cell controller 200-2 through the bus bar 500. The master BMS 110 may transmit the received first history information and/or second history information to the blockchain network 700. For example, a signal including the first history information and/or the second history information may be transmitted from each of a plurality of devices 1001 and 1001' to the blockchain network 700. The blockchain network 700 may store the first history information and/or the second history information included in the received signal in nodes 701 constituting the blockchain network 700 in a distributed manner. Since the first history information and/or the second history information are stored in the blockchain network 700, the forgery and/or tempering of the first history information and/or the second history information may be prevented.

For example, when the battery module 100 is replaced, the master BMS 110 may provide the first history information and/or the second history information to the user. Since the first history information and/or the second history information are stored in the nodes 701 of the blockchain network 700 in a distributed manner, the forgery and/or tampering thereof may be prevented. When the battery module 100 is reused, the reliability of the first history information and/or the second history information may be guaranteed, and thus, the stability and reliability of reuse may be ensured.

For example, when the first battery cell 120-1 within the battery module 100 is replaced, the master BMS 110 may provide the first history information to the user. Since the first history information is stored in the nodes 701 of the blockchain network 700 in a distributed manner, the forgery and/or tampering thereof may be prevented. When the first battery cell 120-1 is reused, the reliability of the first history information may be guaranteed, and thus, the stability and reliability of reuse may be ensured. According to one embodiment, the reliability of reuse may be provided without a separate authentication procedure, and thus, the reuse of the battery module 100 and the first battery cell 120-1 may be easily achieved. According to one embodiment, the recycling of the battery module 100 may be promoted, so that the recycling of resources can be activated and the consumption of resources can be reduced.

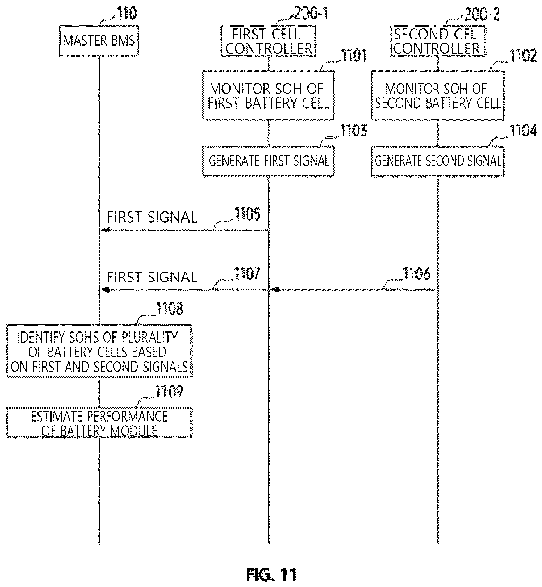

FIG. 11 is a flowchart of an example of the operations of a master BMS and a plurality of cell controllers. The operations of the first cell controller 200-1 and the second cell controller 200-2 described with reference to FIG. 11 may be equally applied to cell controllers for the remaining battery cells.

In operation 1101, the first cell controller 200-1 may be configured to monitor the SOH of the first battery cell (e.g., the first battery cell 120-1 of FIG. 6). For example, the first cell controller 200-1 may be configured to obtain data on at least one of the voltage, current, temperature, and charging and/or discharging-based SOC change of the first battery cell 120-1. The first cell controller 200-1 may be configured to obtain the data independently of whether the first battery cell 120-1 is activated. For example, the first cell controller 200-1 may be configured to, in the state in which the first battery cell 120-1 is activated, measure the temperature, operating voltage, and/or operating current of the first battery cell 120-1 and obtain data related to the measured temperature, operating voltage, and/or operating current. For example, the first cell controller 200-1 may be configured to, in the state in which the first battery cell 120-1 is inactivated (e.g., a sleep state, or a turn-off state), measure the open circuit voltage of the first battery cell 120-1 and obtain data related to the measured open circuit voltage. The above-described data is merely exemplary, and the present disclosure is not limited thereto. The first cell controller 200-1 may be configured to monitor the SOH of the first battery cell 120-1 based at least in part on the above data.

In operation 1102, the second cell controller 200-2 may be configured to monitor the SOH of the second battery cell (e.g., the second battery cell 120-2 of FIG. 6). Operation 1102 may be substantially the same as operation 1101. Operation 1102 may be performed independently of operation 1101.

In operation 1103, the first cell controller 200-1 may generate a first signal including a first numeric value indicating the SOH of the first battery cell 120-1. For example, the first signal may indicate a variation in the voltage of the first battery cell 120-1 for a discharging current when the first battery cell 120-1 is discharged. For example, the first signal may indicate a variation in the voltage of the first battery cell 120-1 for a charging time when the first battery cell 120-1 is charged. For example, the first signal may indicate a variation in the voltage of the first battery cell 120-1 for a discharging time when the first battery cell 120-1 is discharged. However, the present disclosure is not limited thereto.

In operation 1104, the second cell controller 200-2 may generate a second signal including a second numeric value indicating the SOH of the second battery cell 120-2. Operation 1104 may be substantially the same as operation 1103. Operation 1104 may be performed independently of operation 1103.

In operation 1105, the first cell controller 200-1 may transmit the generated first signal to the master BMS 110 through the bus bar (e.g., the bus bar 500 of FIG. 6). For example, the first cell controller 200-1 may be configured to, in the first state in which the first battery cell 120-1 is operated, transmit the generated first signal to the master BMS 110 through the bus bar 500 without receiving a separate request signal from the master BMS 110. For example, the first cell controller 200-1 may transmit the first signal to the master BMS 110 at every period designated by the user. The first state may refer to a state in which the first battery cell 120-1 supplies power to a load. The first cell controller 200-1 may be configured to transmit obtained data to the master BMS 110 within the first state. However, the present disclosure is not limited thereto. For example, within a second state, which is distinct from the first state, the first cell controller 200-1 may transmit the first signal to the master BMS 110 based on the reception of a signal requesting the transmission of the first signal from the master BMS 110. The second state may refer to a turn-off state in which the first battery cell 120-1 is not supplying power to a load, a low-power operation state, or a sleep state. The master BMS 110 may be configured to, within the second state of the first battery cell 120-1, transmit a signal requesting the transmission of the first signal to the first cell controller 200-1. In the second state, the power consumption of the first battery cell 120-1 may need to be minimized, so that the first cell controller 200-1 may be configured to transmit the data to the master BMS 110 upon receiving the signal. For example, when the first cell controller 200-1 continues to perform the operation of transmitting data to the master BMS 110 in a situation where the driving power of a load is insufficient, there may occur a situation where the load cannot be driven due to lack of power. The first cell controller 200-1 may minimize the power consumption of the first battery cell 120-1 attributable to the transmission of data.

In operation 1106, the second cell controller 200-2 may transmit the generated second signal to the first cell controller 200-1 through the bus bar 500. Operation 1106 may be substantially the same as operation 1105.

In operation 1107, the first cell controller 200-1 may transmit the second signal, received from the second cell controller 200-2, to the master BMS 110. The first cell controller 200-1 may amplify the second signal and transmit it to the master BMS 110. The amount of amplification of the signal may be set based on the intensity that decreases as the second signal passes through the first battery cell 120-1. For example, the amount of amplification may be set based on the impedance inside the first battery cell 120-1.

In operation 1108, the master BMS 110 may be configured to estimate the state of the first battery cell 120-1 based on the first signal and estimate the SOH of the second battery cell 120-2 based on the second signal. For example, the master BMS 110 may be configured to identify whether a difference between the first numeric value and the second numeric value falls within a predetermined reference range. The master BMS 110 may determine the first battery cell 120-1 and the second battery cell 120-2 to be in a normal state based on the identification that the difference falls within the reference range. The master BMS 110 may determine at least one of the first battery cell 120-1 and the second battery cell 120-2 to be in a deteriorated state based on the identification that the difference is outside the reference range.

In operation 1109, the master BMS 110 may estimate the performance of the battery module (e.g., the battery module 100 of FIG. 6) based on the SOHs of the first battery cell 120-1 and the second battery cell 120-2. For example, when the identified SOH of the first battery cell 120-1 is 100% and the identified SOH of the second battery cell 120-2 is 100%, the master BMS 110 may estimate the performance of the battery module 100 to be 100%. For example, when the identified SOH of the first battery cell 120-1 is 90% and the identified SOH of the second battery cell 120-2 is 90%, the master BMS 110 may estimate the performance of the battery module 100 to be 90%. For example, when the identified SOH of the first battery cell 120-1 is 100% and the identified SOH of the second battery cell 120-2 is 80%, the master BMS 110 may estimate the performance of the battery module 100 to be 90%.

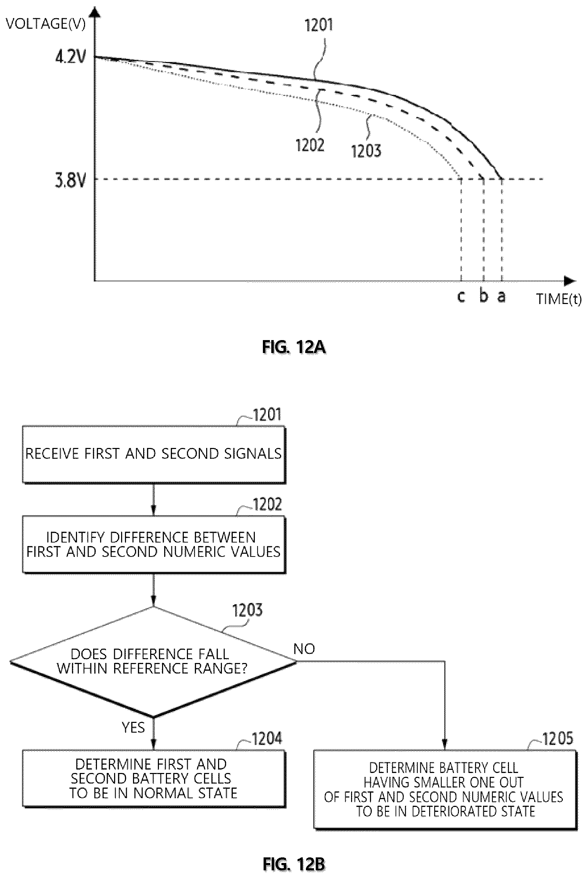

FIG. 12A is a graph showing variations in voltage over time when a battery cell is discharged. FIG. 12B is a flowchart showing how a master BMS determines the deterioration of a battery cell based on variations in voltage over time.

Referring to FIG. 12A, a first graph 1201 shows voltage changes over time during the first discharging of a battery cell immediately after manufacture. The battery cell immediately after manufacture refers to a battery cell before use after the manufacture of the battery cell. The first discharging means the discharging of the battery cell immediately after manufacture for the first time.

A second graph 1202 shows voltage changes over time during the discharging of the first battery cell 120-1. A third graph 1203 shows voltage changes over time during the discharging of the second battery cell 120-2. It is assumed that the discharging currents of the first graph 1201, the second graph 1202, and the third graph 1203 are all constant.

As a battery cell deteriorates, the internal resistance of the battery cell may increase. For example, in the case of a lithium ion battery cell, during charging and discharging, lithium ions move between positive and negative electrodes through a separator inside the battery cell. As the battery cell deteriorates, impurities may be generated inside the battery cell, and the generated impurities may be deposited on the separator. Since the lithium ions cannot actively move due to the impurities, the internal resistance may increase. Accordingly, during constant-current charging and discharging, the voltage increases as the resistance increases, so that the discharging time may be reduced.

Referring to the first graph 1201, when a battery cell immediately after manufacture is first discharged, the time required to discharge from 4.2 V to 3.8 V may be 'a.' Referring to the second graph 1202, when the first battery cell 120-1 is discharged, the time required to discharge from 4.2 V to 3.8 V may be 'b.' 'b' may be smaller than 'a' (a>b). Referring to the third graph 1203, when the second battery cell 120-2 is discharged, the time required to discharge from 4.2 V to 3.8 V may be 'c.' 'c' may be smaller than 'b' (b>c).

According to one embodiment, the first cell controller 200-1 may be configured to generate a first signal including a first numeric value indicating a variation in the voltage of the first battery cell 120-1 for the time of the first battery cell 120-1 when the first battery cell 120-1 is discharged. The first cell controller 200-1 may be configured to transmit the first signal to the master BMS 110 through the bus bar 500. In this case, the first numeric value may be a numeric value corresponding to 'b.' The second cell controller 200-2 may be configured to generate a second signal including a second numeric value representing a variation in the voltage of the second battery cell 120-2 for the time of the second battery cell 120-2 when the second battery cell 120-2 is discharged. The second cell controller 200-2 may be configured to transmit the second signal to the master BMS 110 through the bus bar 500. In this case, the second numeric value may be a numeric value corresponding to 'c.'

Referring to FIG. 12B, in operation 1201, the master BMS 110 may receive a first signal and a second signal through the bus bar 500. The first signal may be transmitted from the first cell controller 200-1 to the master BMS 110. The second signal may be transmitted from the second cell controller 200-2 to the first cell controller 200-1 and then transmitted to the master BMS 110 by the first cell controller 200-1.

In operation 1202, the master BMS 110 may identify a difference (e.g., b-c) between a first numeric value and a second numeric value. The master BMS 110 may identify the first numeric value included in the first signal. The master BMS 110 may identify the second numeric value included in the second signal. The master BMS 110 may compute a difference between the first numeric value and the second numeric value, and may obtain a computation result.

In operation 1203, the master BMS 110 may identify whether the difference falls within a predetermined reference range. For example, the reference range may be designated as a range converted into a ratio for a larger numeric value based on the difference between the first numeric value and the second numeric value. For example, when the first numeric value is 100 and the second numeric value is 90, the difference may be 10 and the ratio may be 90%. For example, the reference range may be determined to be 80 to 100%, but is not limited thereto.

In operation 1204, the master BMS 110 may determine that the first battery cell 120-1 and the second battery cell 120-2 are in a normal state based on the identification of the difference within the reference range. For example, the master BMS 110 may determine that the first battery cell 120-1 and the second battery cell 120-2 are in a normal state based on the identification that the ratio obtained based on the difference falls within the reference range of 80 to 100%. The master BMS 110 may determine that there is no particularly more deteriorated battery cell because the difference in the time required for the first battery cell 120-1 and the second battery cell 120-2 to discharge is not significant.

In operation 1205, the master BMS 110 may be configured to determine a battery cell having a smaller numeric value out of the first numeric value and the second numeric value to be in a deteriorated state based on the identification that the difference is outside the reference range. For example, when the first numeric value is 100 and the second numeric value is 50, the difference may be 50 and the ratio may be 50%. In the above-described example, the master BMS 110 may determine the second battery cell 120-2 having a smaller numeric value to be in a deteriorated state. Since the difference in the time required for the first battery cell 120-1 and the second battery cell 120-2 to discharge is large, the master BMS 110 may determine the second battery cell 120-2 having a shorter discharging time to be deteriorated. The above numeric values are merely exemplary for the purpose of illustration, and the present disclosure is not limited thereto. When the deterioration of a battery cell is determined by the above-described method, deterioration may be detected by relatively comparing a plurality of battery cells. Since the determination of deterioration based on absolute criteria may not be suitable for a device or situation to which a battery module is applied, a battery module according to one embodiment may appropriately determine a deteriorated battery cell by determining deterioration based on relative criteria.

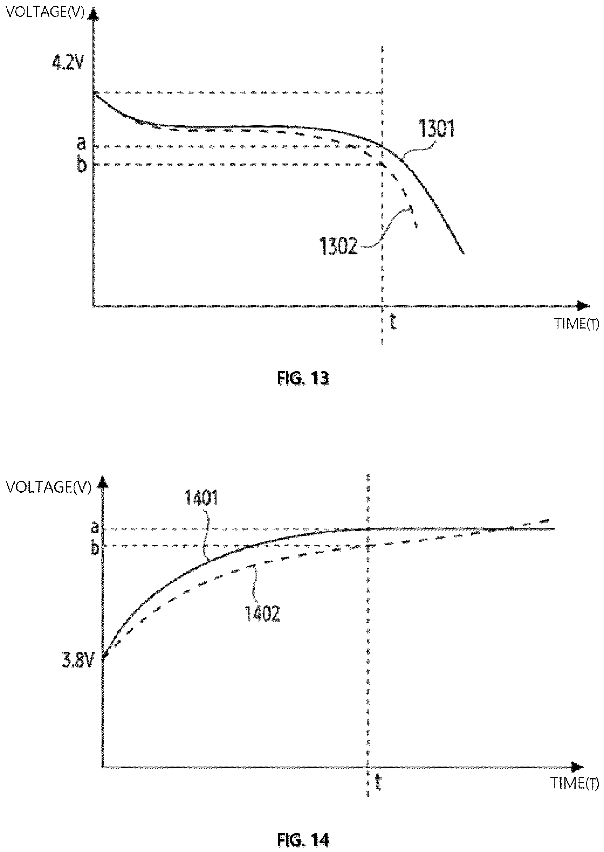

FIG. 13 is a graph showing variations in voltage over time when a battery cell is discharged.

The first graph 1301 of FIG. 13 shows variations in voltage during a specific time t when the first battery cell 120-1 is discharged. The second graph 1302 shows variations in voltage during the specific time t when the second battery cell 120-2 is discharged. Referring to the first graph 1301, during the time t, the first battery cell 120-1 decreases in voltage from 4.2 V to a V. Referring to the second graph 1302, during the time t, the second battery cell 120-2 decreases in voltage from 4.2 V to b V. a V may be higher than b V.

Referring to FIG. 13, when the first battery cell 120-1 is discharged, a variation in the voltage of the first battery cell 120-1 for a discharging time (4.2 V - a V/t) may be smaller than a variation in the voltage of the second battery cell 120-2 for a discharging time (4.2 V - b V/t) when the second battery cell 120-2 is discharged. The deteriorated battery cell may have a lower charging speed and a higher discharging speed due to its high internal resistance. The first cell controller 200-1 may generate a first signal including a numeric value obtained based on the variation in the voltage of the first battery cell 120-1 for the discharging time, and may transmit the generated first signal to the master BMS 110. The second cell controller 200-2 may generate a second signal including a numeric value obtained based on the variation in the voltage of the second battery cell 120-2 for the discharging time, and may transmit the generated second signal to the master BMS 110.

According to one embodiment, the master BMS 110 may be configured to compare the first numeric value included in the first signal with a predetermined reference value and estimate the SOH of the first battery cell 120-1 based on the ratio of the numeric value to the reference value. The master BMS 110 may be configured to compare the second numeric value included in the second signal with a predetermined reference value and estimate the SOH of the second battery cell 120-2 based on the ratio of the numeric value to the reference value. The reference values may be determined based on variations in voltage for discharging times during the first discharging of the first battery cell 120-1 and the second battery cell 120-2.

According to one embodiment, the master BMS 110 may include memory (not shown) that stores data on the discharging of a battery cell immediately after manufacture. The data may be data on a variation in voltage over time when the battery cell immediately after manufacture is discharged. A predetermined reference value may be determined based on the data.

For example, the master BMS 110 may estimate the SOH of the first battery cell 120-1 as 100% when the ratio of the first numeric value to the reference value is 100%. For example, the master BMS 110 may estimate the SOH of the second battery cell 120-2 as 90% when the ratio of the second numeric value to the reference value is 90%. Referring to FIG. 13, it can be seen that the second battery cell 120-2 is more deteriorated than the first battery cell 120-1.

FIG. 14 is a graph showing variations in voltage over time when a battery cell is charged.

The first graph 101 of FIG. 14 shows variations in voltage during a specific time t when the first battery cell 120-1 is charged. The second graph 102 shows variations in voltage during the specific time t when the second battery cell 120-2 is charged. Referring to the first graph 101, during time t, the first battery cell 120-1 increases in voltage from 3.8 V to a V. Referring to the second graph 102, during time t, the second battery cell 120-2 increases in voltage from 3.8 V to b V. a V may be higher than b V.

Referring to FIG. 14, when the first battery cell 120-1 is charged, a variation in the voltage of the first battery cell 120-1 for a charging time (a V - 3.8 V/t) may be larger than a variation in the voltage of the second battery cell 120-2 for a discharging time (b V - 3.8 V/t) when the second battery cell 120-2 is discharged. The deteriorated battery cell may have a lower charging speed and a higher discharging speed due to its high internal resistance. The first cell controller 200-1 may generate a first signal including a numeric value obtained based on the variation in the voltage of the first battery cell 120-1 for the charging time, and may transmit the generated first signal to the master BMS 110. The second cell controller 200-2 may generate a second signal including a numeric value obtained based on the variation in the voltage of the second battery cell 120-2 for the charging time, and may transmit the generated second signal to the master BMS 110.

According to one embodiment, the master BMS 110 may be configured to compare the first numeric value included in the first signal with a predetermined reference value and estimate the SOH of the first battery cell 120-1 based on the ratio of the numeric value to the reference value. The master BMS 110 may be configured to compare the second numeric value included in the second signal with a predetermined reference value and estimate the SOH of the second battery cell 120-2 based on the ratio of the numeric value to the reference value. The reference values may be determined based on variations in voltage for charging times during the initial charging of the first battery cell 120-1 and the second battery cell 120-2.

According to one embodiment, the master BMS 110 may include memory (not shown) that stores data on the charging of a battery cell immediately after manufacture. The data may be data on variations in voltage over time when the battery cell immediately after manufacture is charged. The predetermined reference value may be determined based on the data.

For example, the master BMS 110 may estimate the SOH of the first battery cell 120-1 as 100% when the ratio of the first numeric value to the reference value is 100%. For example, the master BMS 110 may estimate the SOH of the second battery cell 120-2 as 90% when the ratio of the second numeric value to the reference value is 90%. Referring to FIG. 14, it can be seen that the second battery cell 120-2 is more deteriorated than the first battery cell 120-1.

A battery module (e.g., the battery module 100 of FIG. 6) according to one embodiment may include a plurality of battery cells (e.g., the plurality of battery cells 120 of FIG. 6), a master battery management system (BMS) (e.g., the master BMS 110 of FIG. 6), and a bus bar (e.g., the bus bar 500 of FIG. 6). The plurality of battery cells may include a first battery cell (e.g., the first battery cell 120-1 of FIG. 6) and a second battery cell (e.g., the second battery cell 120-2 of FIG. 6). The master BMS may be configured to manage the plurality of battery cells. The bus bar may connect the plurality of battery cells. The bus bar may be electrically connected to the master BMS. The first battery cell may include a first cell controller (e.g., the first cell controller 200-1 of FIG. 6). The first cell controller may be disposed within the first battery cell. The first cell controller may be configured to monitor the state of health (SOH) of the first battery cell. The first cell controller may be configured to obtain a signal including a numeric value indicating the SOH of the first battery cell. The first cell controller may be configured to transmit the signal to the master BMS through the bus bar. The master BMS may be configured to estimate the SOH of the first battery cell based at least in part on the signal.

According to one embodiment, the second battery cell may include a second cell controller (e.g., the second cell controller 200-2 of FIG. 6). The second cell controller may be disposed within the second battery cell. The second cell controller may be configured to monitor the SOH of the second battery cell. The first cell controller may be configured to transmit a first signal, including a first numeric value indicating a time for a variation in the voltage of the first battery cell when the first battery cell is discharged, to the master BMS through the bus bar. The second cell controller may be configured to transmit a second signal, including a second numeric value indicating a time for a variation in the voltage of the second battery cell when the second battery cell is discharged, to the master BMS through the bus bar. The master BMS may be configured to estimate the SOHs of the first battery cell and the second battery cell based on the difference between the first numeric value and the second numeric value.

According to one embodiment, the master BMS may be configured to identify whether the difference falls within a predetermined reference range. The master BMS may be configured to determine the first battery cell and the second battery cell to be in a normal state based on the identification that the difference falls within the reference range. The master BMS may be configured to determine the battery cell having a smaller one out of the first numeric value and the second numeric value to be in a deteriorated state based on the identification that the difference is outside the reference range.

In one embodiment, the first cell controller may generate a signal including a numeric value obtained based on a variation in the voltage of the first battery cell for a charging time when the first battery cell is charged, or may generate a variation in the voltage of the first battery cell for a discharging time when the first battery is discharged. The master BMS may be configured to compare the numeric value included in the received signal with a predetermined reference value. The master BMS may be configured to estimate the SOH of the first battery cell based on the ratio of the numeric value to the reference value.

According to one embodiment, the reference value may be determined based on a variation in the voltage of the first battery cell for a charging time when the first battery cell is first charged, or a variation in the voltage of the first battery cell for a discharging time when the first battery is first discharged.

A battery module according to one embodiment may include a plurality of battery cells including a first battery cell and a second battery cell, a master battery management system (BMS) for managing the plurality of battery cells, master memory, and a bus bar connecting the plurality of battery cells and electrically connected to the master BMS. The first battery cell may include a first cell controller disposed in the first battery cell and configured to communicate with the master BMS through the bus bar, and a first cell memory operatively coupled to the first cell controller. The first cell controller may be configured to generate first history information related to the history of the first battery cell, record the generated first history information in the first cell memory, and transmit a first signal including the generated first history information to the master BMS through the bus bar. The master BMS may be configured to record the first history information included in the first signal in the master memory based on the reception of the first signal from the first cell controller.

According to one embodiment, the first history information may include at least one of the manufacturer, manufacturing date, pre-use state, SOH, charging history, discharging history, and repair history of the first battery cell.

According to one embodiment, the master BMS may be configured to, when the first battery cell out of the plurality of battery cells is replaced, obtain the first history information stored in the first cell memory within the first cell controller through the bus bar, identify the state of the first battery cell based on the obtained first history information, compare the identified state of the first battery cell with a predetermined reference range, identify the replaced first battery cell as usable based on the identification that the state of the first battery cell corresponds to the reference range, and identify the replaced first battery cell as unusable based on the identification that the state of the first battery cell is different from the reference range.

According to one embodiment, the second battery cell may include a second cell controller disposed within the second battery cell and configured to communicate with the master BMS through the bus bar, and second cell memory operatively coupled to the second cell controller. The second cell controller may be configured to generate second history information related to the history of the second battery cell, record the generated second history information in the second cell memory, and transmit a second signal including the generated second history information to the first battery cell through the bus bar. The first cell controller may be configured to receive the second signal received from the second cell controller, may amplify the received second signal, and may then transmit the second signal to the master BMS. The master BMS may be configured to record the second history information included in the second signal in the master memory based on the reception of the second signal from the first cell controller.

According to one embodiment, the master BMS may be configured to transmit the received first history information to a blockchain network based on the reception of the first history information. The first history information may be stored in the blockchain network.

A battery module (e.g., the battery module 100 of FIG. 6) according to one embodiment may include a plurality of battery cells (e.g., the plurality of battery cells 120 of FIG. 6), a master battery management system (BMS) (e.g., the master BMS 110 of FIG. 6), and a bus bar (e.g., the bus bar 500 of FIG. 6). The plurality of battery cells may include a first battery cell (e.g., the first battery cell 120-1 of FIG. 6) and a second battery cell (e.g., the second battery cell 120-2 of FIG. 6). The master BMS may be configured to manage the plurality of battery cells. The bus bar may connect the plurality of battery cells. The bus bar may be electrically connected to the master BMS. The first battery cell may include a first cell controller (e.g., the first cell controller 200-1 of FIG. 6). The first cell controller may be disposed within the first battery cell. The first cell controller may be configured to monitor the state of health (SOH) of the first battery cell. The first cell controller may be configured to obtain a signal including a numeric value indicating the SOH of the first battery cell. The first cell controller may be configured to transmit the signal to the master BMS through the bus bar. The master BMS may be configured to estimate the SOH of the first battery cell based at least in part on the signal.

According to one embodiment, the second battery cell may include a second cell controller (e.g., the second cell controller 200-2 of FIG. 6). The second cell controller may be disposed within the second battery cell. The second cell controller may be configured to monitor the SOH of the second battery cell. The first cell controller may be configured to transmit a first signal, including a first numeric value indicating a time for a variation in the voltage of the first battery cell when the first battery cell is discharged, to the master BMS through the bus bar. The second cell controller may be configured to transmit a second signal, including a second numeric value indicating a time for a variation in the voltage of the second battery cell when the second battery cell is discharged, to the master BMS through the bus bar. The master BMS may be configured to estimate the SOHs of the first battery cell and the second battery cell based on the difference between the first numeric value and the second numeric value.

According to one embodiment, the master BMS may be configured to identify whether the difference falls within a predetermined reference range. The master BMS may be configured to determine the first battery cell and the second battery cell to be in a normal state based on the identification that the difference falls within the reference range. The master BMS may be configured to determine the battery cell having a smaller one out of the first numeric value and the second numeric value to be in a deteriorated state based on the identification that the difference is outside the reference range.

According to one embodiment, the first cell controller may generate a signal including a numeric value obtained based on a variation in the voltage of the first battery cell for a charging time when the first battery cell is charged, or may generate a variation in the voltage of the first battery cell for a discharging time when the first battery is discharged. The master BMS may be configured to compare the numeric value included in the received signal with a predetermined reference value. The master BMS may be configured to estimate the SOH of the first battery cell based on the ratio of the numeric value to the reference value.

According to one embodiment, the reference value may be determined based on a variation in the voltage of the first battery cell for a charging time when the first battery cell is first charged, or based on a variation in the voltage of the first battery cell for a discharging time when the first battery is first discharged.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

Various embodiments as set forth herein may be implemented as software including one or more instructions that are stored in a storage medium that is readable by a machine. For example, a processor of the machine may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A battery module comprising: a plurality of battery cells including a first battery cell and a second battery cell; a master battery management system (BMS) including master memory, and configured to manage the plurality of battery cells; and a bus bar connecting the plurality of battery cells, and electrically connected to the master BMS;
wherein the first battery cell comprises a first cell controller disposed in the first battery cell and configured to communicate with the master BMS through the bus bar, and first cell memory operatively coupled with the first cell controller;
wherein the first cell controller is configured to generate first history information related to history of the first battery cell, record the generated first history information in the first cell memory, and transmit a first signal including the generated first history information to the master BMS through the bus bar; and
wherein the master BMS is configured to record the first history information included in the first signal in the master memory based on reception of the first signal from the first cell controller.

2. The battery module of claim 1, wherein the first history information comprises at least one of a manufacturer, manufacturing date, pre-use state, state of health (SOH), charging history, discharging history, and repair history of the first battery cell.

3. The battery module of claim 1, wherein the master BMS is configured to, when the first battery cell out of the plurality of battery cells is replaced, obtain the first history information stored in the first cell memory within the first cell controller through the bus bar, identify a state of the first battery cell based on the obtained first history information, compare the identified state of the first battery cell with a predetermined reference range, identify the replaced first battery cell as usable based on an identification that the state of the first battery cell corresponds to the reference range, and identify the replaced first battery cell as unusable based on an identification that the state of the first battery cell is different from the reference range.

4. The battery module of claim 1, wherein:
the second battery cell comprises a second cell controller disposed in the second battery cell and configured to communicate with the master BMS through the bus bar, and second cell memory operatively coupled with the second cell controller;
the second cell controller is configured to generate second history information related to history of the second battery cell, record the generated second history information in the second cell memory, and transmit a second signal including the generated second history information to the first battery cell through the bus bar;
the first cell controller is configured to receive the second signal received from the second cell controller, amplify the received second signal, and then transmit the second signal to the master BMS; and
the master BMS is configured to record the second history information included in the second signal in the master memory based on reception of the second signal from the first cell controller.

5. The battery module of claim 1, wherein:
the master BMS is configured to transmit the received first history information to a blockchain network based on reception of the first history information; and
the first history information is stored in the blockchain network.

6. The battery module of claim 1, wherein:
the first cell controller is configured to obtain a signal including a numeric value indicating an SOH of the first battery cell and transmit the signal to the master BMS through the bus bar; and
the master BMS is configured to estimate the SOH of the first battery cell based at least in part on the signal.

7. The battery module of claim 1, wherein:
the second battery cell comprises a second cell controller disposed in the second battery cell and configured to monitor an SOH of the second battery cell;
the first cell controller transmits a first signal, including a first numeric value indicating a time for a variation in voltage of the first battery cell when the first battery cell is discharged, to the master BMS through the bus bar;
the second cell controller transmits a second signal, including a second numeric value indicating a time for a variation in voltage of the second battery cell when the second battery cell is discharged, to the master BMS through the bus bar; and
the master BMS is configured to estimate SOHs of the first battery cell and the second battery cell based on a difference between the first numeric value and the second numeric value.

8. The battery module of claim 7, wherein the master BMS is configured to identify whether the difference falls within a predetermined reference range, determine the first battery cell and the second battery cell to be in a normal state based on an identification that the difference falls within the reference range, and determine the battery cell having a smaller one out of the first numeric value and the second numeric value to be in a deteriorated state based on an identification that the difference is outside the reference range.

9. The battery module of claim 6, wherein:
the first cell controller generates a signal including a numeric value obtained based on a variation in voltage of the first battery cell for a charging time when the first battery cell is charged or based on a variation in voltage of the first battery cell for a discharging time when the first battery is discharged;
the master BMS is configured to compare the numeric value included in the received signal with a predetermined reference value and estimate the SOH of the first battery cell based on a ratio of the numeric value to the reference value; and
the reference value is determined based on a variation in voltage of the first battery cell for a charging time when the first battery cell is first charged or based on a variation in voltage of the first battery cell for a discharging time when the first battery is first discharged.

10. A battery module comprising: a plurality of battery cells including a first battery cell and a second battery cell; a master battery management system (BMS) for managing the plurality of battery cells; and a bus bar connecting the plurality of battery cells and electrically connected to the master BMS;
wherein the first battery cell comprises a first cell controller disposed in the first battery cell and configured to monitor a state of health (SOH) of the first battery cell;
wherein the first cell controller is configured to obtain a signal including a numeric value indicating the SOH of the first battery cell and transmit the signal to the master BMS through the bus bar; and
wherein the master BMS is configured to estimate the SOH of the first battery cell based at least in part on the signal.
